(19) Europäisches Patentamt
European Patent Office
Office européen des brevets

(11) **EP 1 520 341 B1**

(12) **EUROPÄISCHE PATENTSCHRIFT**

(45) Veröffentlichungstag und Bekanntmachung des Hinweises auf die Patenterteilung:
**22.11.2006 Patentblatt 2006/47**

(21) Anmeldenummer: **03763603.2**

(22) Anmeldetag: **09.07.2003**

(51) Int Cl.:
*H03F 3/217* (2006.01)     *H03F 1/30* (2006.01)

(86) Internationale Anmeldenummer:
**PCT/DE2003/002304**

(87) Internationale Veröffentlichungsnummer:
**WO 2004/008632 (22.01.2004 Gazette 2004/04)**

(54) **VERSTÄRKERSCHALTUNG**

AMPLIFIER CIRCUIT

CIRCUIT AMPLIFICATEUR

(84) Benannte Vertragsstaaten:
**DE**

(30) Priorität: **10.07.2002 DE 10231183**

(43) Veröffentlichungstag der Anmeldung:
**06.04.2005 Patentblatt 2005/14**

(73) Patentinhaber: **Infineon Technologies AG**
**81669 München (DE)**

(72) Erfinder: **BERNARDON, Derek**
**A-9500 Villach (AT)**

(74) Vertreter: **Epping - Hermann - Fischer**
**Patentanwaltsgesellschaft mbH,**
**Ridlerstrasse 55**
**80339 München (DE)**

(56) Entgegenhaltungen:
EP-A- 0 503 571     US-A- 5 559 467
US-A1- 2002 060 605

• HANCOCK J: "A CLASS D AMPLIFIER USING MOSFETS WITH REDUCED MINORITY CARRIER LIFETIME*" JOURNAL OF THE AUDIO ENGINEERING SOCIETY, AUDIO ENGINEERING SOCIETY. NEW YORK, US, Bd. 39, Nr. 9, 1. September 1991 (1991-09-01), Seiten 650-662, XP000226144 ISSN: 0004-7554

EP 1 520 341 B1

**Beschreibung**

Die vorliegende Erfindung betrifft eine Verstärkerschaltung.

Zur Verstärkung von Audiosignalen werden üblicherweise unter anderem Klasse D-Verstärker eingesetzt. Gemäß dem zugrundeliegenden Prinzip wird zunächst ein Referenzsignal mit einem vom Ausgang rückgekoppelten Signal verglichen und ein entsprechendes Fehlersignal ausgegeben. Dieses wird unter Zuhilfenahme eines Sägezahnsignals gemäß einer Pulsweitenmodulation verarbeitet und auf eine Ausgangsverstärkerstufe gegeben. Die Ausgangsstufe wird dabei schaltend betrieben mit einem bestimmten Tastverhältnis. Zur Aufrechterhaltung eines Stromflusses am Ausgang ist eine Freilaufdiode sowie eine Induktivität am Ausgang vorgesehen. Somit kann am Ausgang ein konstanter Ausgangsstrom bereitgestellt werden.

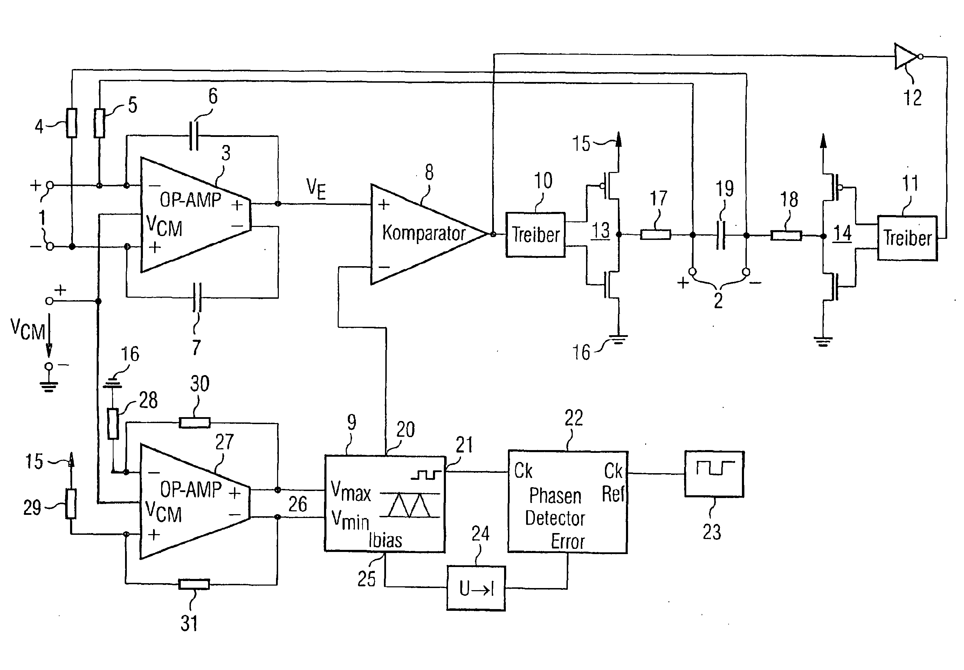

Das "Journal of the Audio Engineering Society", Audio Engineering society, New York, US, Bd. 39, Nr.9, 1 September 1991, Seiten 650, 662 zeigt in Figur 1 eine Verstärkerschaltung mit einem Differenzverstärker, der ausgangsseitig an einen ersten Eingang eines Komparators angeschlossen ist. Einem zweiten Eingang des Komparators wird ein sägezahnförmiges Signal zugeführt. Ausgangsseitig ist der Komparators mit einer Ausgangsschaltung verbunden, die pulsbreitenmoduliert wird.

Druckschrift EP 0503571 A1 zeigt ebenfalls eine pulsbreitenmodulierte Verstärkerschaltung, deren Signaleingang an einen Komparator angeschlossen ist. Einem zweiten Eingang des Komparators wird ein sägezahnförmiges Signal zugeführt. Der Ausgang des Komparators ist an eine Ausgangsstufe angeschlossen.

Derartige Verstärker haben jedoch bezüglich der Versorgungsspannungsunterdrückung, englisch: Power Supply Rejection Ratio, PSRR, verhältnismäßig schlechte Eigenschaften. Betrachtet man das Kleinsignalverhalten einer derartigen Schaltung, so ergibt sich die Ausgangsspannung im Verhältnis zur Eingangsspannung zu

$$\frac{Vout}{Vin} = \frac{d}{1 + s^2 LC},$$

wobei L und C die Werte eines Ausgangsseitigen LC-Filters sind und d das Tastverhältnis der Pulsweitenmodulation. Die Verstärkung der Transferfunktion $v_{out}/v_{in}$ ist demnach proportional zu dem Tastverhältnis d, welches zwischen 0 und 1 liegen kann. Dieser Term bestimmt jedoch den Nenner der Formel zur Beschreibung der Versorgungsspannungsunterdrückung. Demnach führen Schwankungen der Versorgungsspannung oder hochfrequente Störanteile in der Versorgungsspannung zu verhältnismäßig starken, unerwünschten Auswirkungen auf das Ausgangssignal der Verstärkerschaltung.

Ein weiteres Problem des beschriebenen Prinzips liegt in der unerwünschten Faltung von Signalen. Wenn sich die Versorgungsspannung der Ausgangsstufe wie eine verhältnismäßig niederfrequente Sinusschwingung verhält, das Nutzsignal jedoch ebenfalls eine, höherfrequente, Sinusschwingung ist, dann variiert auch die Kleinsignalverstärkung in sinusförmiger Weise. Die resultierenden Harmonischen liegen bei der Summenfrequenz und der Differenzfrequenz der Frequenzen beider Signale mit einer Amplitude, die dem halben Produkt der Amplituden der beiden Signale entspricht. Das Problem ist insbesondere deshalb von großer Bedeutung, da die Störungen bei Frequenzen unterhalt der Eckfrequenz des ausgangsseitigen Tiefpaßfilters liegen können und deshalb nicht herausgefiltert werden.

Der verhältnismäßig schlechten Versorgungsspannungsunterdrükkung wird normalerweise dadurch entgegengewirkt, daß die Signalverstärkung vergrößert wird. Hierdurch steigt jedoch der Stromverbrauch.

Die beschriebene Faltungsproblematik kann durch Reduzieren der Rauschanteile und Störanteile auf der Versorgungsspannung verringert werden, beispielsweise durch Einsatz eines Linearreglers. Hierdurch wird jedoch der Wirkungsgrad des Verstärkers stark verringert.

Aufgabe der vorliegenden Erfindung ist es, eine Verstärkerschaltung anzugeben, die nach dem Klasse D-Prinzip arbeitet und eine verbesserte Versorgungsspannungsunterdrückung hat.

Erfindungsgemäß wird die Aufgabe gelöst durch eine Verstärkerschaltung, umfassend

- einen Eingang zum Zuführen eines zu verstärkenden Nutzsignals,
- einen Ausgang zum Abgreifen eines verstärkten Nutzsignals,
- einen Differenzverstärker mit einem ersten Eingang, der mit dem Eingang der Verstärkerschaltung verbunden ist, mit einem zweiten Eingang, der mit dem Ausgang der Verstärkerschaltung gekoppelt ist und mit einem Ausgang,
- einen Komparator mit einem ersten Eingang, der an den Ausgang des Differenzverstärkers angeschlossen ist, und mit einem zweiten Eingang, an dem ein periodisches Signal zugeführt wird,
- eine Ausgangsstufe mit einem Eingang, der an einen Ausgang des Komparators angeschlossen ist, mit einem Ausgang und mit einem Versorgungsanschluß zur Zuführung einer Versorgungsspannung und
- einen Signalgenerator, der an den zweiten Eingang des Komparators angeschlossen ist und das periodische Signal mit einer Amplitude bereitstellt, die proportional ist zu der Versorgungsspannung der Ausgangsstufe, wobei der Signalgenerator in einer Phasenregelschleife angeordnet ist zur Regelung der Frequenz des periodischen Signals in Abhängigkeit von einem Referenztakt.

Gemäß dem vorgestellten Prinzip wird das zur Pulsweitenmodulation verwendete, periodische Signal so bereitgestellt, daß seine Amplitude stets proportional ist zu der Versorgungsspannung der Verstärkerschaltung, insbesondere der Ausgangsstufe der Verstärkerschaltung.

Es entspricht dem vorgestellten Prinzip, daß das Tastverhältnis stets proportional zu der Versorgungsspannung ist.

Die Transferfunktion der Ausgangsspannung bezogen auf die Versorgungsspannung betrachtet im Kleinsignalverhalten ist gemäß dem beschriebenen Prinzip idealerweise 0, praktischerweise zumindest sehr gering, so daß die Versorgungsspannungsunterdrückung PSRR stark verbessert ist.

Der Quotient aus Versorgungsspannung und der Amplitudenspannung des periodischen Signals ist gemäß vorliegendem Prinzip stets konstant. Dieser Quotient beschreibt aber gerade auch die Kleinsignalverstärkung der Schaltung, demnach arbeitet die beschriebene Schaltung stets mit konstanter Verstärkung derart, daß als zusätzlicher Vorteil keine Faltung mit einem harmonischen Signalanteil der Versorgungsspannung mehr auftreten kann.

Wenn das periodische Signal, welches gemäß vorliegendem Prinzip zur Pulsweitenmodulation dient, beispielsweise ein Rampensignal, ein Dreieckssignal oder ein Sägezahnsignal ist, so bezieht sich die Proportionalität dieses Signals zur Versorgungsspannung darauf, daß die Spitze-Spitze-Spannung des Rampensignals proportional zur Versorgungsspannung ist. Die Spitze-Spitze-Spannung wird auch als peak-to-peak-voltage bezeichnet.

Die Proportionalität des periodischen Signals zur Versorgungsspannung kann bevorzugt mit einem Operationsverstärker hergestellt werden, der eingangsseitig an die Versorgungsspannung angeschlossen ist und ausgangsseitig zur Speisung des Signalgenerators mit diesem gekoppelt ist.

Damit die Frequenz des periodischen Signals trotz der Anbindung der Amplitude des Signals an eine gegebenenfalls schwankende Versorgungsspannung stets konstant bleibt, ist mit Vorteil eine Phasenregelschleife vorgesehen, welche für die Frequenzkonstanz des Signalgenerators sorgt.

Die beschriebene Verstärkerschaltung ist bevorzugt symmetrisch ausgebildet mit zwei Ausgangsstufen, welche jeweils bevorzugt als Inverter realisiert sind. Die Ausgangsknoten der Inverter sind jeweils bevorzugt über eine Serieninduktivität an die Ausgangsklemmen des Ausgangs der Verstärkerschaltung gekoppelt. Zwischen den beiden Ausgangsklemmen ist bevorzugt eine Stabilisierungskapazität geschaltet.

In einer alternativen, digitalen Realisierung des vorgestellten Prinzips ist vorgesehen, daß das Tastverhältnis stets proportional zu der Versorgungsspannung eingestellt wird.

Weitere Einzelheiten und vorteilhafte Ausgestaltungen des vorliegenden Verstärkerprinzips sind Gegenstand der Unteransprüche.

Die Erfindung wird nachfolgend an einem Ausführungsbeispiel anhand der Figur erläutert.

Es zeigt:

die Figur    ein Ausführungsbeispiel des vorgestellten Prinzips anhand eines Blockschaltbildes.

Die Figur zeigt eine Verstärkerschaltung gemäß dem vorliegenden Prinzip anhand eines Blockschaltbildes. Diese umfaßt einen Eingang 1 zum Zuführen eines zu verstärkenden Nutzsignals, welcher als symmetrischer Eingang mit einem Eingangsklemmenpaar ausgeführt ist. Das mit der vorliegenden Verstärkerschaltung verstärkte Signal, welches vom am Eingang 1 anliegenden Signal abgeleitet ist, kann am Ausgang 2, der ebenfalls symmetrisch als Ausgangsklemmenpaar ausgebildet ist, abgegriffen werden.

An den Eingang 1 ist ein Verstärker 3 angeschlossen, der ein aus der Signaldifferenz vom am Eingang 1 anliegenden und vom am Ausgang 2 bereitgestellten Signal bildet. Dieses Differenzsignal wird am symmetrischen Eingang des Operationsverstärkers 3 bereitgestellt. Hierfür ist das Ausgangsklemmenpaar 2 über je einen Widerstand 4, 5 mit dem Eingang des Verstärkers 3 verbunden. Außerdem sind die beiden Ausgangsklemmen des Operationsverstärkers 3 in einer invertierenden Rückkopplung über je einen Kondensator 6, 7 mit den beiden Eingängen des Verstärkers 3 verbunden. Der Verstärker 3 weist zusätzlich zu dem Differenzeingang und dem Differenzausgang noch einen Gleichtakteingang zum Zuführen eines Gleichtaktpegels $V_{CM}$ auf. An diesem ist ein Gleichtaktsignal, ein sogenanntes Common-Mode-Signal, zuführbar.

An eine der beiden Ausgangsklemmen des Differenzverstärkers 3 ist der Plus-Eingang eines Komparators 8 angeschlossen, dessen Minus-Eingang mit einem Signalgenerator 9 verbunden ist. Der Ausgang des zur Pulsweitenmodulation PWM ausgelegten Komparators 8 ist mit einem ersten Ausgangstreiber 10 unmittelbar und mit einem zweiten Ausgangstreiber 11 über einen Inverter 12 verbunden. Die Ausgangstreiber 10, 11 sind jeweils mit den Steuereingängen eines CMOS-Inverters 13, 14 verbunden. Die CMOS-Inverter 13, 14 umfassen jeweils, wie bei CMOS-Invertern üblich, eine lastseitige Serienschaltung eines p-Kanal- und eines n-Kanal-MOS-Transistors, welche zwischen einen Versorgungspotentialanschluß 15 und einen Bezugspotentialanschluß 16 geschaltet sind. Die Ausgänge der CMOS-Inverter 13, 14, welche die Ausgangsstufen des vorliegenden Verstärkers bilden, haben an dem Verbindungsknoten der MOS-Transistoren jeweils ihren Ausgangsknoten. Diese Ausgangsknoten sind über je eine Serieninduktivität 17, 18 mit den Ausgangsklemmen 2 verbunden. Zwischen die Ausgangsklemmen 2 ist eine Stabilisierungskapazität 19 geschaltet, welche zusammen mit den Serieninduktivitäten 17, 18 ein LC-Filter bildet.

Der Signalgenerator 9 ist als Dreiecksignalgenerator ausgebildet, der ein periodisches Signal mit einer Spitze-Spitze-Spannung $V_{max}$-$V_{min}$ an einem Ausgang 20 bereitstellt, die sich aus der Differenz eines oberen Spitzenwertes $V_{max}$ und eines unteren Spitzenwertes $V_{min}$ ergibt.

Die als digitales Taktsignal aufbereitete Frequenz des vom Signalgenerator bereitgestellten, periodischen Signals wird an einem digitalen Taktausgang 21 bereitgestellt, der mit einem ersten Eingang eines Phasendetektors 22 verbunden ist. Ein weiterer Eingang des Phasendetektors 22 ist an eine Referenztaktquelle 23 angeschlossen. Der Ausgang des Phasendetektors 22, an dem eine eventuelle Phasenabweichung der beiden Eingangssignale voneinander bereitsteht, wird über einen Spannungs-Strom-Wandler 24 an den Ruhestromeingang 25 des Signalgenerators 9 geführt.

Die Amplitude $V_{max}$-$V_{min}$ wird an einem symmetrisch ausgebildeten Amplitudensteuereingang 26 des Signalgenerators 9 eingestellt. An diesen ist der Differenzausgang eines weiteren Operationsverstärkers 27 angeschlossen. Der Minus-Eingang des Operationsverstärkers 27 ist über einen Widerstand 28 an Bezugspotential 16 geschaltet. Der Plus-Eingang des Operationsverstärkers 27 ist über einen weiteren Widerstand 29 an Versorgungspotentialanschluß 15 angeschlossen. Versorgungs- und Bezugspotentialanschluß 15, 16 stimmen dabei mit den Versorgungsspannungsanschlüssen 15, 16 der Ausgangsstufen 13, 14 des Verstärkers überein. Der Operationsverstärker 27 hat ebenfalls einen Gleichtakteingang, der mit dem Gleichtakteingang des Operationsverstärkers 3 zur Zuführung des Gleichtaktsignals $V_{CM}$ verbunden ist. Der Operationsverstärker 27 weist bezüglich des Differenzausgangs eine negative Rückkopplung auf den Differenzeingang über je einen Widerstand 30, 31 auf.

Man erkennt deutlich, daß die Spitze-Spitze-Spannung $V_{max}$-$V_{min}$ des vom Signalgenerator 9 bereitgestellten Rampensignals proportional ist zur Versorgungsspannung des Verstärkers. Der Bias-Strom des Signalgenerators 9 wird von einer Phasenregelschleife gesteuert, um die Frequenz des periodischen Signals konstant zu halten, während sich die Spitze-Spitze-Spannung $V_{max}$-$V_{min}$ ändert. Wichtig bei der Auslegung der Schaltung ist es, zu beachten, daß die Bandbreite beider Regelschleifen, nämlich die des Verstärkers und die des Phasenreglers, größer sind als die Grenzfrequenz des Tiefpaßfilters.

Mit der vorliegenden Verstärkerschaltung ist die Linearität der Ausgangsstufe signifikant verbessert. Eine weitere Verbesserung könnte beispielsweise durch Vergrößerung der Bandbreite der offenen Schleifenverstärkung erzielt werden. Mit der vorgestellten Feed-Forward-Technik besteht keine Notwendigkeit einer Fehlerkompensation für irgendwelche Störanteile auf der Versorgungsspannung.

Wie bereits erläutert ermöglicht das beschriebene Prinzip, nämlich die Spitze-Spitze-Spannung des periodischen Signals proportional zur Versorgungsspannung einzustellen, eine deutliche Verbesserung der Versorgungsspannungsunterdrückung und zugleich eine weitgehende Vermeidung von unerwünschten Faltungseffekten. Das beschriebene Prinzip ist dabei mit besonders einfachen schaltungstechnischen Mitteln und mit geringem Aufwand realisierbar.

Anstelle der gezeigten analogen Ansteuerung des Referenzsignalgenerators 9 mit dem Ziel, das Tastverhältnis unabhängig von der Versorgungsspannung konstant zu halten, kann auch eine digitale Realisierung vorgesehen sein. Hierfür würde die Versorgungsspannung mit einem Analog/Digital-Wandler in ein digitales Spannungssignal gewandelt und das Tastverhältnis der Pulsweitenmodulation proportional zur Versorgungsspannung nachgeführt.

Bezugszeichenliste

| | |
|---|---|
| 1 | Eingang |
| 2 | Ausgang |
| 3 | Differenzverstärker |
| 4 | Widerstand |
| 5 | Widerstand |
| 6 | Kondensator |
| 7 | Kondensator |
| 8 | Komparator |
| 9 | Signalgenerator |
| 10 | Treiber |
| 11 | Treiber |
| 12 | Inverter |
| 13 | CMOS-Inverter |
| 14 | CMOS-Inverter |
| 15 | Versorgungspotentialanschluß |
| 16 | Bezugspotentialanschluß |
| 17 | Induktivität |
| 18 | Induktivität |
| 19 | Kondensator |
| 20 | Rampensignalausgang |
| 21 | Taktausgang |
| 22 | Phasendetektor |
| 23 | Referenztaktquelle |
| 24 | U/I-Wandler |
| 25 | Bias-Stromeingang |
| 26 | Amplitudensteuereingang |
| 27 | Operationsverstärker |
| 28 | Widerstand |
| 29 | Widerstand |
| 30 | Widerstand |
| 31 | Widerstand |

**Patentansprüche**

1. Verstärkerschaltung, umfassend

   - einen Eingang (1) zum Zuführen eines zu verstärkenden Nutzsignals,
   - einen Ausgang (2) zum Abgreifen eines verstärkten Nutzsignals,
   - einen Differenzverstärker (3) mit einem ersten Eingang, der mit dem Eingang der Verstärkerschaltung verbunden ist, mit einem zweiten Eingang, der mit dem Ausgang der Verstärkerschaltung gekoppelt ist und mit einem Ausgang,
   - einen Komparator (8) mit einem ersten Eingang, der an den Ausgang des Differenzverstärkers (3) angeschlossen ist, und mit einem zweiten Eingang, an dem ein periodisches Signal zugeführt wird,
   - eine Ausgangsstufe (13) mit einem Eingang, der an einen Ausgang des Komparators (8) angekoppelt ist, mit einem Ausgang und mit einem Versorgungsanschluß (15) zur Zuführung einer Versorgungsspannung und
   - einen Signalgenerator (9), der an den zweiten Eingang des Komparators (8) angeschlossen ist und das periodische Signal mit einer Amplitude bereitstellt, die proportional ist zu der Versorgungsspannung der Ausgangsstufe, wobei der Signalgenerator (9) in einer Phasenregelschleife (9, 22, 24) angeordnet ist zur Regelung der Frequenz des periodischen Signals in Abhängigkeit von einem Referenztakt.

2. Verstärkerschaltung nach Anspruch 1,
   **dadurch gekennzeichnet, daß**
   ein Operationsverstärker (27) vorgesehen ist mit zwei Eingängen, die mit einem Versorgungs- und einem Bezugspotentialanschluß (15, 16) verbunden sind zum Zuführen der Versorgungsspannung der Ausgangsstufe (13) und mit einem Ausgang, der mit einem Amplitudensteuereingang (26) des Signalgenerators (9) verbunden ist.

3. Verstärkerschaltung nach Anspruch 1 oder 2,
   **dadurch gekennzeichnet, daß**
   die Phasenregelschleife (9, 22, 24) einen Phasendetektor (22) umfaßt mit einem ersten Takteingang, der mit einem Taktausgang des Signalgenerators (9) zum Übertragen der Frequenz des periodischen Signals verbunden ist, mit einem zweiten Eingang, der mit einer Referenzquelle (23) zum Zuführen des Referenztakts verbunden ist, und mit einem Ausgang, der mit einem Ruhestromeingang des Signalgenerators (9) gekoppelt ist.

4. Verstärkerschaltung nach einem der Ansprüche 1 bis 3,
   **dadurch gekennzeichnet, daß**
   der Signalgenerator (9) als Rampensignalgenerator oder als Sägezahnsignalgenerator ausgebildet ist.

5. Verstärkerschaltung nach einem der Ansprüche 1 bis 4,
   **dadurch gekennzeichnet, daß**
   ein Filter (17, 18, 19) vorgesehen ist, welches eine Serieninduktivität (17) umfaßt und an den Ausgang der Ausgangsstufe (13) angeschlossen ist.

6. Verstärkerschaltung nach einem der Ansprüch 1 bis 5,
   **dadurch gekennzeichnet, daß**
   die Verstärkerschaltung einen symmetrischen Ausgang (2) aufweist mit einer weiteren Ausgangsstufe (14), die einen Eingang hat, der über einen Inverter (12) an den Ausgang des Komparators (8) angekoppelt ist.

7. Verstärkerschaltung nach Anspruch 6,
   **dadurch gekennzeichnet, daß**
   die Ausgangsstufe (13) und die weitere Ausgangsstufe (14) je einen CMOS-Inverter umfassen.

8. Verstärkerschaltung nach Anspruch 6 oder 7,
   **dadurch gekennzeichnet, daß**
   das Filter (17, 18, 19) eine weitere Serieninduktivität (18) umfaßt, die die weitere Ausgangsstufe (14) mit dem Ausgang (2) koppelt.

**Claims**

1. Amplifier circuit comprising

   - an input (1) for supplying a useful signal which is to be amplified,
   - an output (2) for tapping off an amplified useful signal,
   - a differential amplifier (3) having a first input, which is connected to the input of the amplifier circuit, having a second input, which is coupled to the output of the amplifier circuit, and having an output,
   - a comparator (8) having a first input, which is connected to the output of the differential amplifier (3), and having a second input, to which a periodic signal is supplied,
   - an output stage (13) having an input, which is coupled to an output on the comparator (8), having an output and having a supply connection (15) for supplying a supply voltage, and
   - a signal generator (9) which is connected to the second input of the comparator (8) and provides the periodic signal at an amplitude which is proportional to the supply voltage for the output stage, the signal generator (9) being arranged in a phase locked loop (9, 22, 24) for the purpose of regulating the frequency of the periodic signal on the basis of a reference clock.

**2.** Amplifier circuit according to Claim 1, **characterized in that** an operational amplifier (27) is provided which has two inputs, which are connected to a supply potential connection and to a reference potential connection (15, 16) for the purpose of supplying the supply voltage for the output stage (13), and which has an output, which is connected to an amplitude control input (26) on the signal generator (9).

**3.** Amplifier circuit according to Claim 1 or 2, **characterized in that** the phase locked loop (9, 22, 24) comprises a phase detector (22) having a first clock input, which is connected to a clock output on the signal generator (9) for the purpose of transmitting the frequency of the periodic signal, having a second input, which is connected to a reference source (23) for the purpose of supplying the reference clock, and having an output, which is coupled to a quiescent current input on the signal generator (9).

**4.** Amplifier circuit according to one of Claims 1 to 3, **characterized in that** the signal generator (9) is in the form of a ramp signal generator or is in the form of a sawtooth signal generator.

**5.** Amplifier circuit according to one of Claims 1 to 4, **characterized in that** a filter (17, 18, 19) is provided which comprises a series inductor (17) and is connected to the output of the output stage (13).

**6.** Amplifier circuit according to one of Claims 1 to 5, **characterized in that** the amplifier circuit has a symmetrical output (2) having a further output stage (14), which has an input which is coupled to the output of the comparator (8) via an inverter (12).

**7.** Amplifier circuit according to Claim 6, **characterized in that** the output stage (13) and the further output stage (14) each comprise a CMOS inverter.

**8.** Amplifier circuit according to Claim 6 or 7, **characterized in that** the filter (17, 18, 19) comprises a further series inductor (18), which couples the further output stage (14) to the output (2).

**Revendications**

**1.** Circuit amplificateur comportant

- une entrée (1) pour l'entrée d'un signal utile à amplifier,
- une sortie (2) pour prélever un signal utile amplifié,
- un amplificateur (3) différentiel comportant une première entrée, qui est reliée à l'entrée du circuit amplificateur, une deuxième entrée, qui est couplée à la sortie du circuit amplificateur et une sortie,
- un comparateur (8) comportant une première entrée, qui est raccordée à la sortie de l'amplificateur (3) différentiel, et une deuxième entrée, à laquelle est envoyé un signal périodique,
- un étage (13) de sortie comportant une entrée, qui est couplée à une sortie du comparateur (8), une sortie et une borne (15) d'alimentation pour appliquer une tension d'alimentation, et
- un générateur (9) de signal, qui est raccordé à la deuxième entrée du comparateur (8) et qui met à disposition le signal périodique avec une amplitude qui est proportionnelle à la tension d'alimentation de l'étage de sortie, le générateur (9) de signal étant disposé dans une boucle (9, 22, 24) d'asservissement de phase pour la régulation de la fréquence du signal périodique en fonction d'une cadence de référence.

**2.** Circuit amplificateur suivant la revendication 1, **caractérisé en ce qu'**il est prévu un amplificateur (27) opérationnel qui comporte deux entrées, qui sont reliées à une borne (15, 16) d'alimentation et à une borne de potentiel de référence pour appliquer la tension d'alimentation de l'étage (13) de sortie et une sortie, qui est reliée à une entrée (26) de commande d'amplitude du générateur (9) de signal.

**3.** Circuit amplificateur suivant la revendication 1 ou 2, **caractérisé en ce que** la boucle (9, 22, 24) d'asservissement de phase comporte un détecteur (22) de phase, comportant une première entrée de cadencement, qui est reliée à une sortie de cadencement du générateur (9) de signal pour la transmission de la fréquence du signal périodique, une deuxième entrée, qui est reliée à une source (23) de référence pour l'amenée de la cadence de référence et une sortie, qui est couplée à une entrée de courant de repos du générateur (9) de signal.

**4.** Circuit amplificateur suivant l'une des revendications 1 à 3, **caractérisé en ce que** le générateur (9) de signal est réalisé sous la forme d'un générateur de signal à rampe ou sous la forme d'un générateur de signal en forme de dents de scie.

**5.** Circuit amplificateur suivant l'une des revendications 1 à 4, **caractérisé en ce qu'**il est prévu un filtre (17, 18, 19) qui comporte une inductance (17) série et qui est raccordé à la sortie de l'étage de sortie (13).

**6.** Circuit amplificateur suivant l'une des revendications 1 à 5, **caractérisé en ce** le circuit amplificateur comporte une sortie (2) symétrique comportant un étage (14) de sortie supplémentaire qui a une entrée qui est couplée par l'intermédiaire d'un inverseur (12) à la sortie du comparateur (8).

**7.** Circuit amplificateur suivant la revendication 6, **caractérisé en ce que** l'étage (13) de sortie et l'étage (14) supplémentaire comportent chacun un inverseur CMOS.

**8.** Circuit amplificateur suivant la revendication 6 ou 7, **caractérisé en ce que** le filtre (17, 18, 19) comporte une inductance (18) série supplémentaire, qui effectue le couplage de l'étage (14) de sortie supplémentaire avec la sortie (2).

EP 1 520 341 B1